Europäisches Patentamt

European Patent Office

Office européen des brevets

(11) Publication number: 0 394 826
A2

# EUROPEAN PATENT APPLICATION

(21) Application number: 90107368.4

(51) Int. Cl.5: H01L 21/208, C30B 19/04

(22) Date of filing: 18.04.90

(30) Priority: 28.04.89 JP 111611/89

(43) Date of publication of application:
31.10.90 Bulletin 90/44

(84) Designated Contracting States:
DE FR GB

(71) Applicant: Toshiba Corporation
72, Horikawa-cho Saiwai-ku
Kawasaki-shi(JP)

(72) Inventor: Ueki, Yujiro, Intellectual Property
Division
K.K. Toshiba, 1-1 Shibaura 1-chome
Minato-ku, Tokyo 105(JP)

(74) Representative: Lehn, Werner, Dipl.-Ing. et al
Hoffmann, Eitle & Partner Patentanwälte
Arabellastrasse 4
D-8000 München 81(DE)

(54) Liquid crystal epitaxial growing method and apparatus therefor.

(57) A crystalline semiconductor substrate (10) for liquid phase epitaxial growth is placed in a sealed condition between a substrate holder (3) and an upper solution containing member (2) which are opposed each other, and is heated from room temperature to a high temperature. A predetermined amount of a solution mixture consisting of a Group III-V compound semiconductor and a dopant is added to the crystalline semiconductor substrate (10) which is annealed, thereby forming a liquid phase epitaxial growth layer on the crystalline semiconductor substrate (10).

F I G. 3

EP 0 394 826 A2

## Liquid crystal epitaxial growing method and apparatus therefor

The present invention relates to a liquid phase epitaxial growing (to be referred to as LPE hereinafter) method suitably used to perform LPE for a Group III-V semiconductor compound single crystal such as GaP, GaAs or GaAℓAS for use in a light-emitting device or a laser device, and an apparatus therefor.

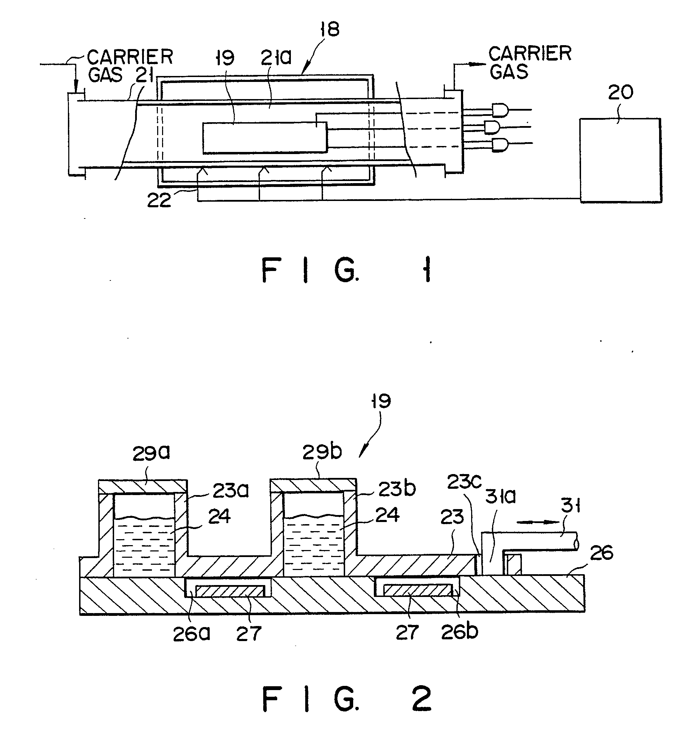

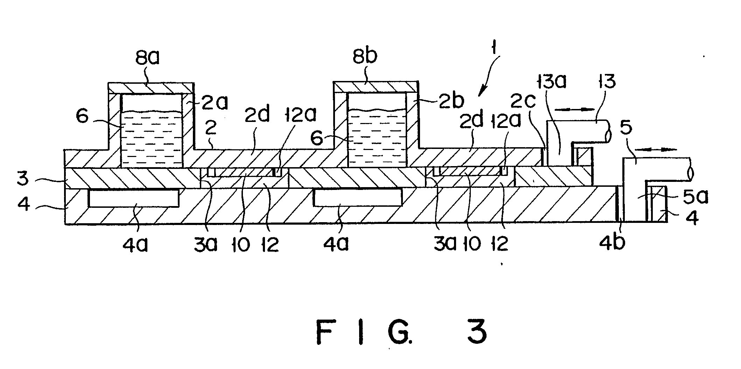

As a method of manufacturing a Group III-V semiconductor compound single crystal such as GaP, GaAs, GaAlAs and the like, a temperature difference method using a gas partial pressure, a vapor phase growth method and an LPE method, i.e., an annealing method are known. Various types of semiconductor devices are manufactured by using Group III-V semiconductor compound single crystals manufactured by these methods. The LPE method of these methods will be described with reference to Figs. 1 and 2.

Fig. 1 is a sectional view showing a schematic arrangement of a conventional LPE apparatus. This LPE apparatus comprises a quartz tube 21 serving as a reaction tube and a heating unit 18. Ar or $H_2$ carrier gas is flowed in the quartz tube 21. The heating unit 18 is located at the center of the LPE apparatus, and thermocouples 22 connected to a temperature adjusting device 20 is located at the lower portion of the reaction tube. A main part 19 of the LPE apparatus is located inside the quartz tube 21 in a uniform heat region 21a which is a temperature flat zone at the center of the LPE apparatus.

Fig. 2 is a sectional view showing the main part 19 of the LPE apparatus shown in Fig. 1. An upper solution container member 23 is arranged on a substrate holder 26. Upper solution containers 23a and 23b are formed in the upper solution container member 23, and a hole 23c is formed in its end portion. The containers 23a and 23b contain respectively supersaturated or saturated solution 24, 24 consisting of, e.g., GaP, GaAs, polycrystal, dopant and the like. Cover members 29a and 29b are arranged respectively on the upper surfaces of the containers 23a and 23b and a bent portion 31a at the distal end of a manipulating rod 31 is movably fitted in the hole 23c of the upper solution container member 23. The upper surface of the substrate holder 26 is a flat surface, and holes 26a and 26b each for receiving a crystalline semiconductor substrate 27 to be subjected to LPE are formed in the upper surface.

When the manipulating rod 31 fitted in the hole 23c is moved in directions indicated by arrows shown in Fig. 2, the solutions 24, 24 are injected from the upper solution containers 23a and 23b in the holes 26a and 26b in each of which the crystalline semiconductor substrate 27 is arranged. While a carrier gas is flowed in the quartz tube 21 at a flow rate of 0.3 to 5 ℓ/min, each semiconductor substrate 27 is held in the uniform heat region 21a which is maintained at 1,050 to 1,100°C for 60 to 90 minutes, thereby reliably performing LPE. Thereafter, the semiconductor substrate 27 is annealed to 800°C at a temperature gradient of 0.5 to 2°C/min. As the temperature falls upon annealing, a supersaturated polycrystal is formed as an LPE layer consisting of single crystals.

In order to form this LPE layer, the substrate holder 26 which holds the substrates 27 in the holes 26a and 26b and the containers 23a and 23b which contain the predetermined solutions 24, 24 respectively are arranged in the uniform heat region 21a of the quartz tube 21. Heating and annealing are then performed in accordance with a predetermined temperature gradient.

When the temperature is increased beyond room temperature, the substrate 27, i.e., a Gap or GaAs substrate to be subjected to LPE is in contact with a carrier gas until predetermined amount of the solutions are injected. Therefore, phosphorus (P) or arsenic (As) is released from the GaP, GaAs or GaAℓAs substrate, i.e., so-called gas etching occurs to adversely affect the LPE layer to be grown thereafter. That is, in a light-emitting device or a laser device, a poly-element compound consisting of a Group III-V semiconductor compound is used and a compound of elements in amounts of fractions in terms of a stoichiometric ratio is used. Therefore, a stoichiometric ratio essential to an LPE film consisting of a Group III-V semiconductor compound is adversely affected to disable predetermined characteristics to be achieved.

The present invention has been made in consideration of the above situation and has as its object to provide an LPE method which can form an LPE film which is not adversely affected by gas etching on a crystalline semiconductor substrate and an apparatus therefor.

In the present invention, a crystalline semiconductor substrates are sealed between a substrate holder and an upper solution container member which oppose each other, and are heated from room temperature to a high temperature. A predetermined amount of a solution mixture consisting of a Group III-V compound semiconductor and a dopant is added to the crystalline semiconductor substrate which is then annealed, thereby forming an LPE layer on the crystalline semiconductor substrate.

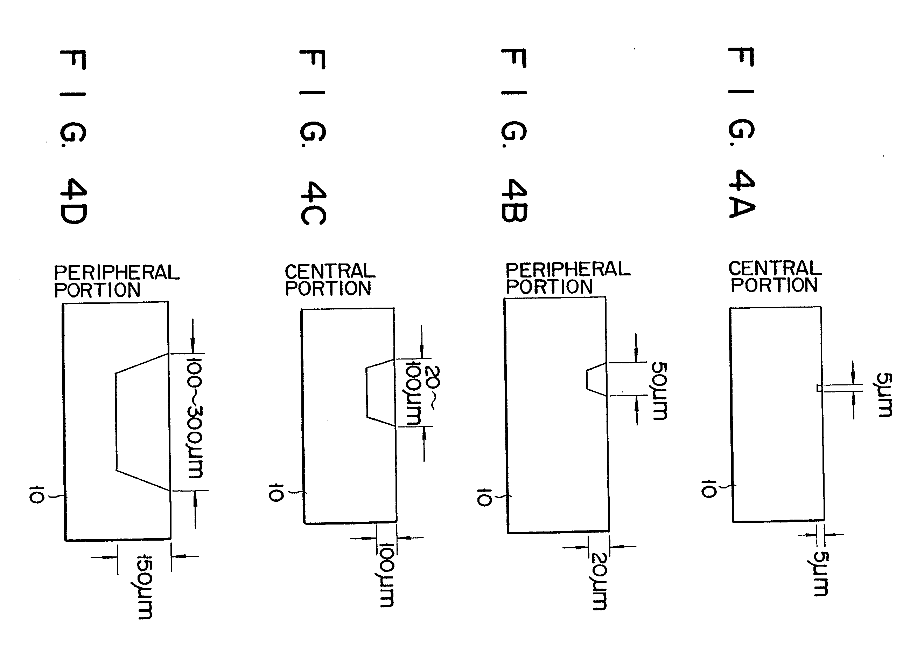

When the Group III-V compound semiconductor layer is formed by the LPE method on the crystalline semiconductor substrate which has been heated in a carrier gas atmosphere from room temperature to a predetermined reaction temperature, almost no arsenic or phosphorus is gas-etched from the surface of the crystalline semiconductor substrate since the surface is in contact with the substrate holder. This fact was found by the present inventor. On the basis of this fact, the surface of a crystalline semiconductor substrate on which a Group III-V compound semiconductor layer was to be formed was sealed and heated in a carrier gas atmosphere and then a predetermined LPE layer was formed. As a result, an LPE layer having a surface with a very good appearance and not adversely affected by gas etching was obtained as shown in Fig. 4. The resultant structure was heated under the sealed condition to form a solution mixture of a Group III-V compound semiconductor polycrystal as an LPE source and a dopant solution, thereby forming an LPE layer on the crystalline semiconductor substrate.

In an LPE apparatus (boat) of the present invention, in order to obtain the sealed condition, a bottom blocking member is additionally provided to a double-layered structure which is constituted by the upper solution container member and the substrate holder, so that the heating step and the LPE step in the sealed condition can be performed respectively in different places.

More specifically, in the heating step, openings of through holes formed in the substrate holder to receive the crystalline semiconductor substrates are closed by the upper solution containing member and the bottom blocking member to obtain the sealed condition and then the substrates are heated. In the LPE step, the crystalline semiconductor substrate is moved into a hole formed in the bottom blocking member, and a solution mixture of a polycrystalline solution of a Group III-V compound semiconductor and a dopant solution formed in solution containers of an upper solution container member in the heating step is injected through an empty through hole, thereby forming an LPE layer having a predetermined thickness.

All of the upper solution container member, the substrate holder and the bottom blocking member are formed of a conductive material, e.g., carbon to be maintained at the same temperature in the heating step.

In order to perform the above steps, the upper solution container member, the substrate holder and the bottom blocking member are allowed to move relative to each other. Normally, the substrate holder is fixed while the upper solution container member and the bottom blocking member are moved.

In the sealed condition in the present invention, the presence of a slight gap is permitted between the two components. In general, however, a crystalline semiconductor substrate of 300 to 500 μm thickness is fixed on a storage jig for crystalline semiconductor substrate and placed in a through hole of 0.5 mm depth, thereby substantially eliminating a clearance between the semiconductor substrate and the upper solution containing member.

This storage jig also serves as a protecting member during movement of the crystalline semiconductor substrate consisting of a hard and brittle Group III-V compound semiconductor such as GaAs into the hole in the bottom blocking member.

In the LPE step, since the solution mixture consisting of a Group III-V compound semiconductor polycrystal and the dopant are injected in an empty through hole, an LPE layer having a predetermined thickness can be formed. As a result, not only a crystalline semiconductor substrate which is not adversely affected by gas etching, but also an LPE layer having a predetermined thickness and a predetermined composition can be formed.

This invention can be more fully understood from the following detailed description when taken in conjunction with the accompanying drawings, in which:

Fig. 1 is a sectional view showing a schematic arrangement of a conventional LPE apparatus;

Fig. 2 is a sectional view showing a main part of the LPE apparatus shown in Fig. 1;

Fig. 3 is a sectional view showing a main part of an LPE apparatus for use in an LPE method according to the present invention; and

Figs. 4A, 4B, 4C and 4D are sectional views schematically showing micrographs of formed LPE layer, in which Figs. 4A and 4B show LPE layer obtained by the present invention and Figs. 4C and 4D show those obtained by conventional methods.

There will now be described an embodiment of the paresent invention with reference to the accompanying drawings.

An LPE method and an apparatus therefor according to the present invention will be described in detail below with reference to Fig. 3 and Figs. 4A to 4D. A part of the descriptions will be made with reference to Fig. 1. An upper solution containing member 2, a substrate holder 3 and a bottom blocking member 4 are vertically arranged in a quartz tube 21 serving as a reaction tube of an LPE apparatus 1, thereby constituting the LPE apparatus 1 shown in Fig. 3. The upper solution containing member 2, the substrate holder 3 and the bottom blocking member 4 consist of a conductive material.

As is apparent from Fig. 1, while a uniform heat region 21a in the quartz tube 21 is maintained at a predetermined temperature with heating the quartz tube 21 by a heating unit 22, a carrier gas such as Ar is flowed at a predetermined rate of 0.3 to 5ℓ/min. As shown in Fig. 3, in the region 21a of the LPE apparatus 1, solution mixtures 6 and 6 consisting of a Group III-V compound semiconductor polycrystal and a dopant are arranged in upper solution containers 2a and 2b.

The present invention is characterized in that the bottom blocking member 4 is arranged below the substrate holder 3 so that the surface of a crystalline semiconductor substrate 10 consisting of a Group III-V compound semiconductor is kept in contact with the bottom surface of the substrate holder 3 and then the substrate is heated to form an LPE layer.

Upper solution containers 2a and 2b for containing the solution mixtures 6 and 6 consisting of a polycrystal of a Group III-V compound semiconductor such as GaP, GaAs or the like and the dopant, respectively, are formed in the upper solution containing member 2. Cover members 8a and 8b are formed on the containers 2a and 2b, respectively, thereby preventing evaporation of the Group III-V compound semiconductor polycrystal having a high vapor pressure. In order to allow movement of the upper solution containing member 2 on the substrate holder 3, a hole 2c is formed in a bottom plate 2d so that a bent portion 13a at the distal end of a manipulating rod 13 is fitted therein. Through holes 3a and 3a are formed in the substrate holder 3 at positions corresponding to the bottom plates 2d and 2d of the upper solution containing member 2. A crystalline semiconductor substrates 10 of 250 to 300-μm thickness is placed in each through hole 3a as will be described later. The bottom plate 2d of the upper solution containing member 2 and the upper surface of the bottom blocking member 4 located below the through holes 3a cover the upper and lower openings of each through hole 3a, thereby sealing the through hole 3a.

The crystalline semiconductor substrate 10 is fixed in an upper recess portion 12a of a substrate storage jig 12 and the storage jig 12 is placed in the through hole 3a so that the substrate 10 is substantially brought into contact with the bottom plate 2d of the upper solution containing member 2 covering the opening of the through hole 3a. Therefore, the depth of the through hole 3a is adjusted in accordance with the thicknesses of the substrate 10 and the jig 12 as needed. The substrate storage jig 12 also serves as a protecting member used when the Group III-V compound semiconductor consisting of hard and brittle GaAs, Gap and the like is moved from the through hole 3a to a hole 4a formed in the bottom blocking member 4.

In order to allow movement of the bottom blocking member 4 similar to the upper solution containing member 2, a through hole 4b for receiving a bent portion at the distal end of a manipulating rod 5 is formed in the end portion of the bottom blocking member 4. The sealed condition described above is obtained by moving the bottom blocking member 4 with respect to the substrate holder 3 to a predetermined position as shown in Fig. 3. In this embodiment, the bottom blocking member 4 is moved while the substrate holder 3 is fixed. The present invention, however, is not limited to this embodiment. For example, while the bottom blocking member 4 is fixed, the substrate holder 3 and the upper solution containing member 2 may be moved. That is, the LPE apparatus 1 need only be arranged such that these members can move relative to each other.

An inert gas such as Ar or a reduction gas such as hydrogen gas is filled in or flowed through the quartz tube 21 in which the crystalline semiconductor substrate 10 is sealed. The quartz tube 21 is then heated from room temperature to 900 to 1,100°C and held at this temperature for 20 to 120 minutes, thereby forming solution mixtures 6 and 6 consisting of the Group III-V compound semiconductor polycrystal and the dopant in the upper solution containers 2a and 2b, respectively. For example, a solution mixture of gallium, GaAs polycrystal, aluminum and dopant (zinc (p type) or tellurium (n type)) is heated to melt and homogeneously diffuse the other additives, i.e., the GaAs polycrystal, aluminum and the dopant in gallium.

The bottom blocking member 4 is moved by the above manipulation using the manipulating rod 5 so that the through holes 3a and 3a of the substrate holder 3 coincide with the holes 4a and 4a of the bottom blocking member 4, thereby dropping the crystalline semiconductor substrates 10 in the substrate storage jigs 12 into the holes 4a and 4a. The upper solution containing member 2 is moved by the manipulating rod 13 to inject predetermined amount of the solution mixtures 6 and 6 on the surface of each semiconductor substrate 10 exposed in the hole 4a. Thereafter, the LPE apparatus 1 is annealed at a rate of 0.3 to 2.0°C/min to form an LPE layer on the surface of the semiconductor substrate 10. Upon this annealing, since a predetermined space is formed above the semiconductor substrate 10 placed in a space formed by facing the hole 4a and the through hole 3a, an LPE layer having a predetermined thickness can be formed on the semiconductor substrate 10.

Figs. 4A to 4D are sectional views schematically showing micrographs of LPE layers formed by such an LPE method. As is apparent from Figs. 4A and 4B, the section of the LPE layer is not damaged by gas etching but smooth. That is, even if arsenic or phosphorus is more or less released from the LPE layer, the formed cavity has a length of less than 5 μm and a depth of 5 μm at the

central portion of the LPE layer (Fig. 4A) and a length of less than 50 μm and a depth of 20 μm at its peripheral portion (Fig. 4B). To the contrary, a large number of linear or curved cavities from which arsenic or phosphorus is removed are found on LPE layers formed by the conventional techniques. That is, as shown in Figs. 4C and 4D, a cavity having a length of 20 to 100 μm and a depth of 100 μm is formed at the central portion of the LPE layer (Fig. 4C) and that having a length of 100 to 300 μm and a depth of 150 μm is formed at its peripheral portion (Fig. 4D). If is obvious from Figs. 4A to 4D that the LPE layer according to the present invention has a perfectly smooth surface and is subjected to almost no damage by gas etching as compared with those obtained by the conventional techniques. Therefore, a light-emitting element or a semiconductor laser element using the LPE layer according to the present invention can satisfactorily achieve predetermined characteristics.

Reference signs in the claims are intended for better understanding and shall not limit the scope.

## Claims

1. A liquid phase epitaxial growing method comprising:
the first step of placing a crystalline semiconductor substrate (10) in a sealed condition between a substrate holder (3) and an upper solution containing member (2) which are opposed each other; and
the second step of adding a predetermined amount of a solution mixture (6) consisting of a Group III-V compound semiconductor and a dopant in said crystalline semiconductor substrate (10), and annealing said substrate (10) to form a liquid phase epitaxial growth layer on said crystalline semiconductor substrate (10).

2. A method according to claim 1, characterized in that the sealed condition is formed by closing upper and lower openings of through holes (3a, 3a) formed in said substrate holder (3) to store said crystalline semiconductor substrate (10) with a bottom surface of said solution containing member (2) and a upper surface of a bottom blocking member (4).

3. A liquid phase epitaxial growing apparatus for forming a liquid phase epitaxial growth layer on a crystalline semiconductor substrate (10), comprising:
a substrate holder (3) having through holes (3a, 3a) for storing a crystalline semiconductor substrate (10);
an upper solution containing member (2) having upper solution containers (2a, 2b) for a solution mixture, movably placed on said substrate holder (3) in contact therewith, and covering upper portions of said through holes (3a, 3a) with a bottom surface thereof; and
a bottom blocking member (4) having holes (4a, 4a) for storing said crystalline semiconductor substrate (10) in an upper surface position corresponding to said through holes (3a, 3a), movably arranged on a lower portion of said substrate holder (3) in contact therewith, and closing lower portions of said through holes (3a, 3a) with an upper surface thereof.

4. An apparatus according to claim 3, characterized by further comprising a substrate storage jig (12), fitted in said through holes (3a, 3a), in said substrate holder (3), for holding said crystalline semiconductor substrate (10).

5. An apparatus according to claim 3, characterized in that said substrate holder (3), said upper solution containing member (2) and said bottom blocking member (4) consist of a conductive material.

F I G. 1

F I G. 2

F I G. 3

F I G. 4A

F I G. 4B

F I G. 4C

F I G. 4D